# FASCICULE DE BREVET EUROPEEN

(11) **EP 1 359 390 B1**
(45) Date de publication et mention de la délivrance du brevet: **23.05.2012**
(21) Numéro de dépôt: 03291030.9
(22) Date de dépôt: 28.04.2003
(51) Int. Cl.: H01L 21/02, H01L 21/66, G01N 21/956, G01N 21/95, H01L 21/18, G01B 11/30

(54) **Dispositif et procédé de controle automatique de l'état de surface de plaque par mesure de vitesse de collage**
Vorrichtung und Verfahren zur automatischen Zustandsüberwachung einer Platte durch Schweissgeschwindigkeitsmessen
Device and method for the automatic control of the state of a surface of a plate by measuring the bonding speed

(30) Priorité: 30.04.2002 FR 0205427
(43) Date de publication de la demande: 05.11.2003
(73) Titulaire: Soitec, 38190 Bernin (FR)
(72) Inventeur: Maleville, Christophe, 38660 La Terrasse (FR); Metral, Frédéric, 38210 Saint-Quentin sur Isere (FR)
(74) Mandataire: Texier, Christian

(56) Documents cités:
- WO-A1-01/99154
- JP-A- 7 320 994
- US-A1- 2005 231 713
- US-B1- 6 181 431
- PATENT ABSTRACTS OF JAPAN vol. 007, no. 006 (P-167), 11 janvier 1983 (1983-01-11) & JP 57 166505 A (ASAHI GLASS KK), 14 octobre 1982 (1982-10-14)
- PATENT ABSTRACTS OF JAPAN vol. 1996, no. 01, 31 janvier 1996 (1996-01-31) & JP 07 245470 A (MATSUSHITA ELECTRIC IND CO LTD), 19 septembre 1995 (1995-09-19)

## Description

La présente invention concerne de manière générale le traitement des matériaux, et plus particulièrement de substrats pour l'électronique, l'optique ou l'optoélectronique.

Plus précisément, l'invention concerne un dispositif de caractérisation de la vitesse de collage entre deux plaques de matériaux.

Et l'invention concerne également un procédé permettant de mettre en oeuvre un tel dispositif.

On connaît déjà des dispositifs du type mentionné ci-dessus.

En particulier, il est connu de caractériser la vitesse de collage entre deux plaques de matériaux, dont une plaque au moins est réalisée en un matériau semi-conducteur tel que du silicium.

De telles plaques ont généralement un contour en forme de disque dont l'épaisseur est typiquement de l'ordre de quelques centaines de microns.

Ces plaques peuvent être collées deux à deux pour constituer des structures multicouches, les deux plaques collées ensemble pouvant être en des matériaux différents.

Par ailleurs, les spécifications d'état de surface de telles plaques peuvent être extrêmement sévères, en particulier pour les plaques destinées à être mises en oeuvre pour constituer des substrats du type mentionné ci-dessus.

Et dans la perspective d'un collage des plaques entre elles, ces spécifications d'état de surface sont encore renforcées, notamment en termes de rugosité de la surface de la plaque et d'absence d'impuretés sur cette surface.

Il apparaît ainsi qu'il est particulièrement important de disposer de moyens performants pour caractériser cet état de surface.

Un moyen connu pour caractériser l'état de surface de deux plaques (l'une des plaques au moins pouvant être notamment en un matériau semi-conducteur tel que le silicium, et les deux plaques ayant le même contour de disque) est de réaliser les opérations suivantes :
- mettre en contact les surfaces respectives de ces plaques, de manière à constituer une tranche ayant la forme générale d'un disque et comprenant les deux plaques accolées,
- comprimer la tranche formée par les deux plaques en un point quelconque de cette tranche,
- mesurer le temps nécessaire à l'établissement d'une liaison entre les deux plaques, suite à cette compression.

Ce temps est nommé « temps de collage ».

On précise que le « collage » correspond en réalité à la formation de liaisons hydrogènes entre les surfaces des deux plaques (plus précisément entre des liaisons OH des surfaces respectives des deux plaques).

Pour déterminer la vitesse de collage, un opérateur chronomètre le temps séparant la compression initiale de l'arrivée d'une onde de collage à l'autre extrémité de la tranche, ladite onde de collage pouvant être visualisée au travers des plaques par transmission d'un rayonnement infrarouge issu d'une source placée sous la tranche, l'utilisateur observant cette tranche par le dessus (par l'intermédiaire de moyens tels qu'un écran restituant l'image fournie par une caméra infrarouge située au-dessus de la tranche).

Et la vitesse de collage est représentative de l'état de surface des plaques : une vitesse de collage importante indique un bon état de surface, alors qu'une vitesse de collage moins importante indique la présence de défauts et/ou d'impuretés à la surface des plaques.

On précise que les surfaces des plaques en sortie d'une chaîne de fabrication présentent quelques défauts et résidus qui sont à la fois de nature chimique (principalement des liaisons OH avec les particules superficielles des plaques) et de nature mécanique (typiquement des défauts de rugosité, des présences de particules abrasives et de contaminants métalliques superficiels).

Pour améliorer cet état de surface, on fait généralement précéder la mesure de la vitesse de collage, d'un nettoyage des plaques consistant à plonger celles-ci successivement dans :
- au moins un bain basique. Cette étape a pour objectif de développer l'hydrophylie des plaques, en créant à la surface desdites plaques des liaisons de type OH,
- puis un bain acide, afin d'éliminer de la surface des plaques les éléments contaminants (en particulier métalliques) qui ont pu être amenés par les étapes antérieures de traitement des plaques (et en particulier par le bain basique).

On dispose donc d'une méthode connue pour caractériser l'état des surfaces de plaques.

Mais un inconvénient lié à cette méthode est qu'elle est effectuée de manière manuelle par un observateur qui réalise les différentes étapes (placement des plaques sur le dispositif de mesure, compression initiale, suivi de la progression de l'onde de collage, chronométrage permettant de déterminer la vitesse de collage, ...).

En outre, il est selon cet état de la technique nécessaire de réaliser les mesures de vitesse de collage sur un dispositif manuel dédié à une telle mesure : le collage de ces plaques ne peut donc être réalisé automatiquement.

Or il existe par ailleurs des dispositifs qui permettent de réaliser un collage automatique de plaques, à des fins de collage opérationnel et non de caractérisation de l'état de la surface.

On pourrait certes imaginer de permettre à un opérateur de mettre en oeuvre de tels dispositifs de collage automatique pour réaliser en conjonction avec le collage une mesure de vitesse de collage, qui permettrait d'accéder à une information de la qualité de l'état de surface des plaques.

Mais une telle utilisation des dispositifs de collage automatique par un opérateur n'est actuellement pas envisageable.

En effet, l'ensemble des micro-mécanismes présents au dessus et en dessous du support permettant le positionnement, l'alignement et le collage des plaques ne permet pas à l'opérateur de visualiser l'onde de collage.

Ainsi, la caractérisation de la vitesse de collage ne peut actuellement être réalisée que manuellement, sur un dispositif dédié.

Ceci limite naturellement de manière très sensible les cadences que l'on peut obtenir.

On connaît du document WO 01/994154 un procédé et un dispositif permettant de nettoyer et de coller deux plaques, dans lequel les plaques sont mises en contact et comprimées ensemble. Une caméra infrarouge, Insérée entre la plaque et une surface de protection, détecte une lumière infrarouge émise latéralement par une source afin de rendre apparente la qualité du collage par contraste.

Par ailleurs, le document US 6 181 431 propose un système de test non destructif d'une liaison entre deux éléments (notamment des soudures, des revêtements minces, etc.) mettant en oeuvre un laser pulsé et des moyens de détection d'une onde thermo-élastique.

Un but de l'invention est de permettre de s'affranchir de cette limitation.

Afin d'atteindre ce but, l'invention propose selon un premier aspect un dispositif de contrôle de l'état de surface de plaque mettant en oeuvre une mesure de vitesse de collage de deux plaques au niveau d'une interface de collage définie entre les deux plaques, caractérisé en ce que le dispositif comprend des moyens de détection automatique de début de collage et des moyens de détection automatique de passage d'une onde de collage.

Des aspects préférés, mais non limitatifs d'un tel dispositif sont les suivants :
- les moyens de détection automatique de passage d'une onde de collage comprennent une source de rayonnement électromagnétique et un capteur apte à détecter au moins une partie du spectre du rayonnement électromagnétique émis par la source, le capteur étant disposé de manière à recueillir le rayonnement issu d'un endroit de mesure déterminé de l'interface de collage,
- le dispositif comprend une unité de traitement à laquelle sont reliés les moyens de détection automatique de début de collage et les moyens de détection automatique de passage d'une onde de collage,
- l'unité de traitement est apte à calculer des vitesses instantanées de collage, pour chaque endroit de mesure de l'interface de collage,
- le capteur est apte à détecter un changement d'une caractéristique de l'onde électromagnétique qu'il reçoit de la source par l'intermédiaire d'au moins un endroit de mesure,
- le changement de caractéristique de l'onde électromagnétique est un changement de contraste,
- les moyens de détection automatique de passage d'une onde de collage comprennent en outre, en association avec au moins un endroit de mesure, une ouverture respective traversant le support et laissant passer le rayonnement issu de la source afin que celui-ci traverse ensuite les plaques au niveau de l'endroit de mesure, pour que la partie du rayonnement issu de la source qui a été transmise au travers des plaques aboutisse au capteur,
- les moyens de détection comprennent au moins un ensemble de détection constitué d'une source électromagnétique, d'une ouverture et d'un capteur électromagnétique tels que la source et le capteur sont alignés de part et d'autre de l'ouverture,
- les moyens de détection automatique de passage d'une onde de collage comprennent en outre, en association avec au moins un endroit de mesure, une source de rayonnement électromagnétique dirigé vers l'endroit de mesure et réfléchi par les plaques vers un capteur associé,
- la source est de type lampe,
- le capteur est optoélectronique,
- le spectre électromagnétique émis par la source comprend le domaine des infrarouges,
- le dispositif comprend une pluralité d'ensembles de détection de passage d'onde de collage entre les deux plaques, associés respectivement à une pluralité d'endroits de mesure des plaques à contrôler, de sorte que chacun de ces ensembles autorise une détermination locale d'un moment de collage local au niveau de l'endroit de mesure associé,
- les moyens de détection automatique de moment de collage comprennent une pluralité d'ouvertures associées respectivement à des endroits de mesure, chaque ouverture autorisant une détection locale de moment de collage local au niveau de la région de détection associée.

Selon un deuxième aspect, l'invention propose également un procédé de contrôle de l'état de surface de plaque mettant en oeuvre une mesure de vitesse de collage de deux plaques au niveau d'une interface de collage, caractérisé en ce que le procédé comprend les opérations suivantes :
- Acquisition automatique d'un moment de début de collage,
- Acquisition automatique d'un moment de passage d'une onde de collage,
- Détermination automatique d'une vitesse de collage à partir de ces deux acquisitions.

Des aspects préférés, mais non limitatifs du procédé selon l'invention sont les suivants :
- les moments de passage d'une onde de collage sont acquis au niveau d'un endroit de mesure des plaques, à partir d'un changement d'une caractéristique d'une onde électromagnétique issue de l'endroit de mesure,
- le changement de caractéristique de l'onde électromagnétique est un changement de contraste,
- le spectre de l'onde électromagnétique comprend le domaine des infrarouges,
- plusieurs moments de passage local d'une onde de collage sont détectés respectivement en plusieurs endroits de mesure des plaques.

Enfin, selon un troisième aspect l'invention propose également l'application d'un dispositif ou d'un procédé selon un des aspects ci-dessus, pour le contrôle de l'état de surface de plaque d'épaisseur moyenne comprise entre quelques micromètres à quelques millimètres.

Des aspects préférés, mais non limitatifs d'une telle application sont les suivants :
- la structure de plaque contrôlée comprend du silicium,
- la structure de plaque contrôlée comprend une structure de type SOI.

D'autres aspects, buts et avantages, de l'invention apparaîtront à la lecture de la description détaillée qui suit. L'invention sera aussi mieux comprise à l'aide des références aux dessins suivants :
- La figure 1 représente schématiquement un dispositif conforme à l'invention,
- La figure 2 représente un exemple de progression dans le temps d'une onde de collage entre deux tranches accolées et définissant entre elles une interface de collage ne présentant pas de défauts,
- La figure 3 représente un exemple de progression dans le temps d'une onde de collage entre deux tranches accolées et définissant entre elles une interface de collage présentant un défaut.

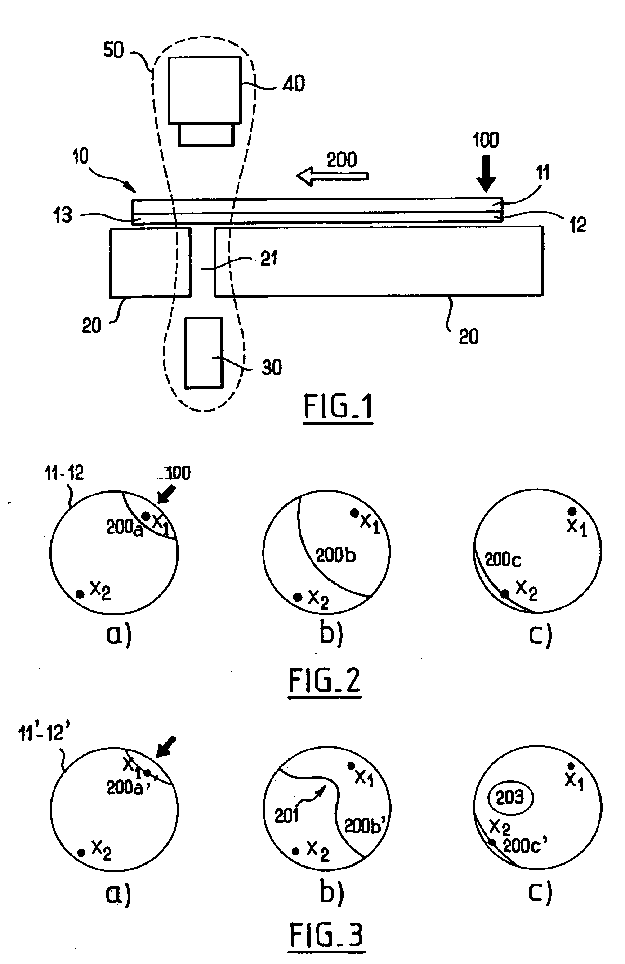

En référence tout d'abord à la figure 1, une tranche 10 est constituée de deux plaques 11 et 12 accolées l'une avec l'autre, de manière à définir entre elles une interface dite de collage 13.

On précise que le terme « accolé » doit dans le présent texte être distingué de « collé » :
- deux plaques « accolées » sont simplement disposées de manière à être en contact l'une avec l'autre, aucune liaison n'existant entre les plaques,
- alors que deux plaques « collées » sont en outre solidaires l'une de l'autre, des liaisons (par exemple du type hydrogène) existant entre les plaques.

La tranche 10 est posée sur un support de collage 20.

On précise qu'avantageusement, ces plaques 11 et 12 ont été préalablement plongées dans des bains basique et acide tels que mentionnés ci-dessus, afin de les nettoyer.

On précise que le dispositif de la figure 1 est représenté de manière très schématique : ce dispositif peut en réalité comprendre également l'ensemble des micromécanismes mentionnés en introduction de ce texte à propos des dispositifs de collage automatique connus.

Ainsi, l'invention peut être mise en oeuvre en adaptant un tel dispositif de collage automatique de type connu.

Par souci de simplification, de tels micromécanismes (qui peuvent être disposés au-dessus et/ou en-dessous des plaques) ne sont pas représentés sur les figures.

La surface du support 20 recevant la tranche 10 doit être particulièrement plane, notamment si on étudie des plaques 11 et 12 ayant une surface importante et une épaisseur de l'ordre de quelques microns.

En effet, une mauvaise planéité du support 20 peut entraîner des distorsions de la plaque 12 par rapport à la plaque 11, et donc perturber la tranche 10 au niveau de l'interface de collage 13.

Une source 30 de rayonnement électromagnétique et un capteur 40 apte à détecter au moins une partie du spectre de ce rayonnement électromagnétique émis par la source 30, constituent avec une ouverture 21 du support 20 un ensemble 50 de détection de passage d'un front d'onde de collage.

La source 30 dirige son rayonnement vers le capteur 40, au travers de l'ouverture 21.

Ce rayonnement est intercepté par la tranche 10 lorsque celle-ci est en position sur le dispositif. Les propriétés des matériaux constituant la tranche 10, et du rayonnement issu de la source 30, sont choisis de sorte qu'une partie significative de ce rayonnement traverse la tranche et que cette partie transmise au travers de la tranche parvienne au capteur 40.

Dans le cas de deux plaques de silicium, on pourra par exemple choisir un rayonnement et un capteur fonctionnant dans l'infra rouge.

On précise qu'il n'est pas obligatoire de disposer les éléments de l'ensemble 50 alignés, comme sur la figure 1 (la source 30 et le capteur 40 étant sur cette figure alignés de part et d'autre de l'ouverture 21).

Il est en effet possible de prévoir des miroirs de renvoi entre la source 30, l'ouverture 21 et le capteur 40. Dans ce cas, les miroirs assurent l'acheminement du rayonnement issu de la source 30 :
- vers l'ouverture 21, en dirigeant le rayonnement selon l'axe de cette ouverture,
- puis de la tranche qui est traversée par le rayonnement vers la capteur 40.

La source 30 est préférentiellement une lampe blanche.

L'émission de la source 30 comprend préférentiellement un spectre d'ondes infrarouges.

Le capteur 40 est préférentiellement un appareil optoélectronique.

L'ouverture 21 pratiquée dans le support 20 joue le rôle de fenêtre électromagnétique et permet donc au rayonnement électromagnétique émise par la source 30 de traverser le support 20 et d'être détectées par le capteur 40.

L'ouverture 21 traverse le support 20 en un endroit X de ce support qui se trouve en regard de la tranche 10 lorsque celle-ci est positionnée sur le dispositif.

L'ouverture 21 doit être suffisamment large pour éviter des perturbations trop importantes des ondes électromagnétiques émises par la source 30.

Ces perturbations peuvent par exemple être une perte importante du signal par réflexion sur la face du support 20 la plus proche de la source 30.

Ces perturbations peuvent aussi être des diffractions et/ou des absorptions des ondes.

L'ouverture 21 doit être aussi suffisamment étroite pour s'affranchir de la présence de tout matériel entourant les plaques, spécifiques du dispositif automatique de collage des plaques.

En outre, le fait d'employer une ouverture 21 de faible diamètre permet de diminuer la quantité de rayonnement issu de la source 30, dirigé vers le capteur 40 et intercepté par la tranche 10: ceci diminue également les possibilités d'échauffement local des plaques qui constituent la tranche.

La largeur de l'ouverture 21 est typiquement de l'ordre de quelques millimètres.

Il est également possible de prévoir plusieurs ouvertures du type de l'ouverture 21, prévues en divers endroits du support (ces endroits se trouvant toujours en regard d'une partie déterminée de la tranche 10 lorsque celle-ci est en position).

Dans ce cas, chaque ouverture peut être traversée par le rayonnement de la source 30 (grâce à des miroirs de séparation et de renvoi adaptés), pour aboutir après avoir traversé la tranche à l'endroit concerné par l'ouverture, au capteur 40 (toujours en mettant en oeuvre des miroirs de séparation et de renvoi adaptés à cet effet).

Et il est également possible de prévoir une source et/ou un capteur spécifique, en association avec chaque ouverture (ou avec certaines ouvertures), de manière à recréer des ensembles similaires à l'ensemble 50 pour chaque (ou pour certaines) ouverture(s).

Le dispositif selon l'invention fonctionne comme suit :

Un piston de collage met en contact les deux plaques 11 et 12 au niveau de l'interface 13 en exerçant en un endroit X1 déterminé de la surface de la tranche 10, une pression initiale 100 suffisante pour amorcer un collage entre les deux plaques.

Ce piston est commandé par une instruction envoyée par une unité centrale de traitement, qui est reliée au piston et qui mémorise le moment de début de collage.

En alternative, il est également possible que le moment de début de collage soit déterminé par un détecteur de début de collage associé au piston.

Ce détecteur automatique de début de collage peut être par exemple un transducteur piézo-électrique.

Dans tous les cas, le début de collage est déclenché automatiquement suite à une instruction initiale, et un moment de début de collage associé est mémorisé.

L'instruction initiale peut être fournie par un opérateur ou par un dispositif automatique réglé, par exemple, selon des séquences temporelles gérées par une horloge.

Et la source 30 est activée de manière à émettre en permanence un rayonnement dirigé au travers de la tranche 10 vers le capteur 40 associé à la source.

Le collage se propage ensuite sur toute la surface des plaques, au niveau de l'interface 13, selon une onde 200 de propagation de collage.

Lorsque l'onde de collage 200 parvient à l'endroit « X » de la tranche, c'est à dire au niveau de l'ouverture 21, le capteur 40 détecte alors un changement dans le signal électromagnétique qu'il reçoit de la source 30 via la tranche 10, par rapport au signal de référence qu'il recevait de cette même tranche avant passage de l'onde de collage.

Ce changement de signal électromagnétique traduit typiquement une caractéristique optique du rayonnement de la source, et peut en particulier correspondre à un changement de contraste révélateur d'une apparition de forces de liaison entre les deux plaques 11 et 12, suite à l'établissement de forces hydrogène entre les deux plaques.

Dans le cas d'un changement de contraste, les ondes optiques émises par la source 30 ont un spectre se situant préférentiellement dans les infrarouges.

Dès que le capteur 40 détecte le passage de l'onde de collage à l'endroit X des plaques qui est situé au niveau de l'ouverture 21, il émet un signal de détection de passage de front de collage à l'unité de traitement à laquelle il est également relié.

Cette unité de traitement calcule alors le temps de collage entre le moment de début de collage mémorisé, et le temps de passage de front de collage qui correspond physiquement à l'établissement d'un collage entre les plaques.

Pour calculer ce temps de collage entre les deux points de la tranche (point X1 d'initiation du collage, et point X de détection du passage du front de collage), l'unité de traitement est également reliée à une horloge.

Et la distance entre les points X1 et X étant connue et mémorisée dans l'unité de traitement, cette unité déduit automatiquement une vitesse de collage, qui est caractéristique de l'état de surface des plaques 11 et 12 entre les endroits de mesure X1 et X.

Dans une variante de l'invention, le support 20 est traversé par une pluralité d'ouvertures 21 réparties sur le support 20 de manière à pouvoir détecter en différents endroits des plaques 11 et 12 le passage de l'onde de collage, et permettre à l'unité de traitement de calculer pour chacun de ces endroits une vitesse de collage.

On précise à cet égard que si un même capteur 40 reçoit les signaux correspondant aux rayonnements respectifs qui ont traversé différentes ouvertures du support et différents endroits de la tranche, le capteur comprend des moyens de discrimination des différents signaux (ces signaux pouvant par exemple avoir des longueurs d'ondes spécifiques en fonction de la source d'émission, ou plus généralement de l'ouverture traversée).

Dans une telle variante, l'unité de traitement peut calculer différentes vitesses « instantanées » de collage, pour les différentes ouvertures.

On précise en effet que l'unité de traitement est reliée à tous les capteurs 40, et qu'elle reçoit tous les signaux de passage d'onde de collage aux différents endroits associés à une ouverture du support 20.

Et l'unité de traitement peut ainsi également calculer des vitesses de collage entre deux de ces endroits, par traitement de la différence de temps de passage de l'onde de collage aux deux endroits (les distances entre les différents endroits associés à une ouverture du support étant connues et mémorisées dans l'unité de traitement).

Et il est possible de disposer les ouvertures en des endroits désirés du support, correspondant à des endroits de la tranche auxquels on veut plus particulièrement caractériser la vitesse instantanée de collage.

On pourra ainsi disposer les ouvertures de manière à ce que celles-ci soient régulièrement réparties sur le trajet attendu de l'onde de collage, de manière à suivre la progression de la vitesse de collage lors de la propagation de cette onde.

Optionnellement dans cette variante, il existe plusieurs capteurs 40 et/ou plusieurs sources 30.

Il peut en particulier être associé à chaque source 30 un capteur respectif 40, aligné avec la source et l'ouverture, le capteur et la source se trouvant de part et d'autre de l'ouverture 21.

Dans ce cas, on obtient alors plusieurs ensembles 50 de détection automatique, chacun s'apparentant à l'ensemble 50 représenté figure 1, ces ensembles de détection étant disposés de manière à permettre de déterminer différentes vitesses de collage en différentes régions de la tranche 10, selon l'état de progression de l'onde de collage 200 sur l'interface 13.

L'invention n'est pas limitée aux moyens de détection schématisés sur la figure 1.

L'invention peut mettre en oeuvre tous moyens de détection automatique de début de collage et tous moyens de détection automatique de moment de passage d'un front de collage.

On précise à cet égard qu'il est possible d'exploiter non pas une détection de changement de signal transmis au travers des plaques, mais une détection de changement de signal réfléchi par la tranche10.

On peut en effet constituer des ensembles de détection équivalents à l'ensemble 50, avec une source de rayonnement dirigée sur un endroit prédéterminé de la tranche, ledit endroit réfléchissant le rayonnement de la source vers un capteur associé.

Dans ce cas, ce sont les changements du rayonnement réfléchi qui sont occasionnés par le passage de l'onde de collage, que l'on détecte et exploite pour calculer des vitesses de collage.

Les moyens de détection automatique de moment de passage de front de collage peuvent également comporter un ou plusieurs ensembles de détection automatique, tels que chacun d'entre eux soit apte à détecter un moment de collage en une région locale de l'interface 13.

En référence à la figure 2, sous l'action d'une compression locale initiale 100 en X1 de deux plaques 11 et 12 en contact (compression initiale réalisée par un piston), une onde de collage est amorcée de manière à produire un front 200a (figure 2a), puis se propage (front 200b - figure 2b) et aboutit (front 200c) à un endroit opposé à l'endroit de pression initiale 100 (figure 2c).

Dans l'exemple du dispositif donné figure 1, l'ensemble 50 de détection sera alors préférentiellement placé près du front d'onde 200c en X2, et la vitesse de collage sera déterminée sur la base du temps mis par l'onde de collage pour parcourir la distance séparant l'emplacement X1 de la pression initiale 100 exercée et l'endroit X2 où se situe le point de détection de fin de collage.

En référence à la figure 3, une pression 100 similaire à la pression 100 de la figure 2 est exercée au même endroit X1 sur des plaques 11' et 12' similaires aux plaques 11 et 12 de la figure 2.

La propagation suit plusieurs étapes 200a' (figure 3a), 200b' (figure 3b) et 200c' (figure 3c) correspondantes respectivement aux étapes 200a, 200b et 200c de la figure 2.

La propagation est toutefois perturbée en 201 (figure 3b). Cette perturbation est significative d'un défaut de surface (une rugosité et/ou une présence de résidus particulaires en surface) entre les plaques 11' et 12', qui n'existait pas pour les plaques 11 et 12, et visible en 203 (figure 3c) en fin de collage, sous forme d'une « bulle » entre les deux plaques, indiquant que le collage ne s'est pas correctement effectué dans la région 203 alors que le front d'onde principal 200c' a atteint la périphérie des plaques..

Un ensemble 50 de détection placé en X2, c'est à dire au même endroit que dans le cas de la figure 2, détecterait un retard d'arrivée de l'onde par rapport au cas de la figure 2, étant donné que l'onde a été ralentie par le défaut de surface (202).

On comprend alors comment, en mesurant une vitesse de collage, on arrive à déduire automatiquement l'état de surface de plaque.

Dans une variante d'un dispositif conforme à l'invention comprenant plusieurs ouvertures 21 ou, dans un cas plus général, dans une variante d'un dispositif selon l'invention mettant en oeuvre plusieurs ensembles de détection automatique de moment de collage, les détections étant ainsi effectuées localement sur toute la surface de la tranche 10, on arriverait alors à déterminer localement des cinétiques de collage de plaque, et ainsi à obtenir de plus amples renseignements sur la qualité de l'état de surface de plaque, mais aussi des renseignements quant à la nature et à l'emplacement de défauts de surface éventuels.

Dans ce mode de réalisation, si les détections locales de moments de collage sont suffisamment nombreuses sur toute la surface de la tranche 10, on arrive alors à obtenir une cartographie de l'état de surface de plaque.

Un tel dispositif ou procédé conforme à l'invention s'applique préférentiellement à des plaques destinées à la micro-électronique, soit des plaques de plusieurs centimètres de diamètre pour des épaisseurs de l'ordre du micron ou de plusieurs dizaines de microns.

Ce type de plaques contient alors au moins un matériau semi-conducteur, tel que le silicium.

Dans un mode préférentiel, ces plaques comprennent des structures de type SOI, acronyme anglo-saxon de « Silicon On Insulator ».

Une des deux plaques (11 ou 12) peut alors ne pas être destinée à une application micro-électronique, et peut par exemple jouer le rôle d'une plaque de référence particulièrement plane.

On notera enfin que les mesures effectuées par le dispositif selon l'invention (moments de début de collage, moments de passage des ondes de collage aux différents endroits de mesure, ..) peuvent demeurer mémorisées dans l'unité de traitement, ainsi que les paramètres qui en sont déduits (vitesses de collage, ...).

Ceci permet d'effectuer un suivi des vitesses de collage, et par conséquent de la qualité des plaques produites. Il est également possible dans ce cas d'exploiter l'ensemble de ces données mémorisées, par exemple pour des opérations de maîtrise statistique des processus.

## Revendications

1. Dispositif de contrôle de l'état de surface de plaque mettant en oeuvre une mesure de vitesse de collage de deux plaques (11, 12) au niveau (13) d'une interface de collage définie entre les deux plaques formant une tranche, le dispositif comprenant des moyens de compression adaptés pour comprimer la tranche en un point déterminé (X1) de cette tranche, **caractérisé en ce que** le dispositif comprend en outre des moyens de détection automatique de début de collage adaptés pour détecter l'instant auquel la tranche est comprimée par les moyens de compression et des moyens de détection automatique de passage d'une onde de collage comprenant une source (30) de rayonnement électromagnétique et un capteur (40) apte à détecter au moins une partie du spectre du rayonnement électromagnétique émis par la source (30), le capteur (40) étant disposé de manière à recueillir le rayonnement issu d'un endroit (X) de mesure déterminé de l'interface de collage.

2. Dispositif selon la revendication précédente, **caractérisé en ce que** le dispositif comprend une unité de traitement à laquelle sont reliés les moyens de détection automatique de début de collage et les moyens de détection automatique de passage d'une onde de collage.

3. Dispositif selon la revendication précédente, **caractérisé en ce que** l'unité de traitement est apte à calculer des vitesses instantanées de collage, pour chaque endroit de mesure de l'interface de collage.

4. Dispositif selon l'une des revendications précédentes, **caractérisé en ce que** le capteur (40) est apte à détecter un changement d'une caractéristique de l'onde électromagnétique qu'il reçoit de la source (30) par l'intermédiaire d'au moins un endroit de mesure.

5. Dispositif selon la revendication précédente, **caractérisé en ce que** le changement de caractéristique de l'onde électromagnétique est un changement de contraste.

6. Dispositif selon l'une des revendications précédentes, **caractérisé en ce que** les moyens de détection automatique de passage d'une onde de collage comprennent en outre, en association avec au moins un endroit de mesure, une ouverture respective traversant le support et laissant passer le rayonnement issu de la source afin que celui-ci traverse ensuite les plaques au niveau de l'endroit de mesure, pour que la partie du rayonnement issu de la source qui a été transmise au travers des plaques aboutisse au capteur.

7. Dispositif selon la revendication précédente, **caractérisé en ce que** les moyens de détection comprennent au moins un ensemble (50) de détection constitué d'une source électromagnétique (30), d'une ouverture (21) et d'un capteur électromagnétique (40) tels que le source (30) et le capteur (40) sont alignés de part et d'autre de l'ouverture (21).

8. Dispositif selon l'une des revendications précédentes, **caractérisé en ce que** les moyens de détection automatique de passade d'une onde de collage comprennent en outre, en association avec au moins un endroit de mesure, une source de rayonnement électromagnétique dirigé vers l'endroit de mesure et réfléchi par les plaques vers un capteur associé.

9. Dispositif selon l'une des revendications précédentes, **caractérisé en ce que** la source (30) est de type lampe.

10. Dispositif selon l'une des revendications précédentes, **caractérisé en ce que** le capteur (40) est optoélectronique.

11. Dispositif selon l'une des revendications précédentes, **caractérisé en ce que** le spectre électromagnétique émis par la source (30) comprend le domaine des infrarouges.

12. Dispositif selon l'une des onze revendications précédentes, **caractérisé en ce que** le dispositif comprend une pluralité d'ensembles (50) de détection de passage d'onde de collage entre les deux plaques, associés respectivement à une pluralité d'endroits de mesure des plaques à contrôler, de sorte que chacun de ces ensembles autorise une détermination locale d'un moment de collage local au niveau de l'endroit de mesure associé.

13. Dispositif selon la revendication précédente en combinaison avec la revendication 6 ou 7, **caractérisé en ce que** les moyens de détection automatique de moment de collage comprennent une pluralité d'ouvertures (21) associées respectivement à des endroits de mesure, chaque ouverture (21) autorisant une détection locale de moment de collage local au niveau de la région de détection associée.

14. Procédé de contrôle de l'état de surface de plaque mettant en oeuvre une mesure de vitesse de collage de deux plaques (11, 12) au niveau d'une interface de collage (13) définie entre deux plaques formant une tranche, **caractérisé en ce que** le procédé comprend les opérations suivantes :
• Compression de la tranche en un point déterminé (X1) de ladite tranche,
• Acquisition automatique d'un moment de début de collage par détection de l'instant auquel la tranche est comprimée,
• Acquisition automatique d'un moment de passage d'une onde de collage au niveau d'un endroit de mesure des plaques (11, 12), à partir d'un changement d'une caractéristique d'une onde électromagnétique issue de l'endroit de mesure,
• Détermination automatique d'une vitesse de collage à partir de ces deux acquisitions.

15. Procédé selon la revendication précédente, **caractérisé en ce que** le changement de caractéristique de l'onde électromagnétique est un changement de contraste.

16. Procédé selon l'une des deux revendications précédentes, **caractérisé en ce que** le spectre de l'onde électromagnétique comprend le domaine des infrarouges.

17. Procédé selon l'une des trois revendications précédentes, **caractérisé en ce que** plusieurs moments de passage local d'une onde de collage sont détectés respectivement en plusieurs endroits de mesure des plaques.

18. Application d'un dispositif selon l'une des revendications 1 à 13 ou d'un procédé selon l'une des revendications 14 à 17, pour le contrôle de l'état de surface de plaque d'épaisseur moyenne comprise entre un micromètre et quelques millimètres.

19. Application selon la revendication précédente, **caractérisée en ce que** la structure de plaque contrôlée comprend du silicium.

20. Application selon la revendication précédente, **caractérisée en ce que** la structure de plaque contrôlée comprend une structure de type SOI.

## Claims

1. A device for inspecting wafer surface quality employing measuring the bonding speed of two wafers (11, 12) at a bonding interface (13) defined between the two wafers forming a stack, the device comprising compression means adapted to compress the stack at any point (X1) thereof, **characterized in that** the device further comprises means for automatically detecting bonding initiation adapted to detect the moment at which the stack is compressed by the compression means, and means for automatically detecting the passage of a bonding wave comprising an electromagnetic radiation source (30) and a sensor (40) capable of detecting at least part of the spectrum of the electromagnetic radiation emitted by the source (30), the sensor (40) being arranged so as to collect the radiation derived from a determined measurement site (X) of the bonding interface.

2. The device according to the preceding claim, **characterized in that** the device comprises a processing unit with which the means for automatic detection of bonding initiation and the means for automatic detection of the passage of a bonding wave are connected.

3. The device according to the preceding claim, **characterized in that** the processing unit is capable of computing the instant bonding speeds for each measurement site of the bonding interface.

4. The device according to one of the preceding claims, **characterized in that** the sensor (40) is capable of detecting a change in a characteristic of the electromagnetic wave that it receives from the source (30) via at least one measurement site.

5. The device according to the preceding claim, **characterized in that** the change in the characteristic of the electromagnetic wave is a change in contrast.

6. The device according to one of the preceding claims, **characterized in that** the means for automatically detecting the passage of a bonding wave further comprise, in association with at least one measuring site, a respective opening which passes through the support allowing the radiation from the source to pass through so that it then passes through the wafers at the measuring site, so that the portion of the radiation from the source which is transmitted through the wafers reaches the sensor.

7. The device according to the preceding claim, **characterized in that** the detection means comprise at least one detection assembly (50) constituted by an electromagnetic source (30), an opening (21) and an electromagnetic sensor (40), such that the source (30) and the sensor (40) are aligned either side of the opening (21).

8. The device according to one of the preceding claims, **characterized in that** the means for automatic detection of the passing of a bonding wave further comprise, in association with at least one measuring site, a source of electromagnetic radiation directed towards the measuring site and reflected towards an associated sensor by the wafers.

9. The device according to one of the preceding claims, **characterized in that** the source (30) is of lamp type.

10. The device according to one of the preceding claims, **characterized in that** the sensor (40) is optoelectronic.

11. The device according to one of the preceding claims, **characterized in that** the electromagnetic spectrum emitted by the source (30) comprises the infrared range.

12. The device according to one of the preceding claims, **characterized in that** the device comprises a plurality of assemblies (50) for detecting the passage of a bonding wave between the two wafers, respectively associated with a plurality of measuring sites on the wafers to be inspected, so that each of said assemblies allows local determination of an instant of local bonding at the associated measuring site.

13. The device according to the preceding claim in combination with claim 6 or claim 7, **characterized in that** the means for automatically detecting the instant of bonding comprise a plurality of openings (21) respectively associated with measuring sites, each opening (21) allowing local detection of the instant of local bonding at the associated measuring region.

14. A method for inspecting the surface quality of a wafer, employing measuring the bonding speed of two wafers (11, 12) at a bonding interface (13), defined between two wafers forming a stack, **characterized in that** the method comprises the following operations:
• Compressing the stack at any point (X1) of the said stack;
• Automatic acquisition of the instant of bonding initiation, by detecting the moment at which the stack is compressed;
• Automatic acquisition of the instant of passing of a bonding wave at a measuring site of the wafers (11, 12) from a change in a characteristic of an electromagnetic wave derived from the measuring site;
• Automatic determination of a bonding speed from said two data acquisitions.

15. The method according to the preceding claim, **characterized in that** the change in a characteristic of the electromagnetic wave is a change in contrast.

16. The method according to one of the two preceding claims, **characterized in that** the electromagnetic wave spectrum encompasses the infrared range.

17. The method according to one of the three preceding claims, **characterized in that** a plurality of instants of local passage of a bonding wave are respectively detected at several measuring sites of the wafers.

18. The application of a device according to one of claims 1 to 13 or of a method according to one of claims 14 to 17, for inspecting the surface quality of a wafer with a mean thickness in the range from one micrometer to a few millimeters.

19. The application according to the preceding claim, **characterized in that** the structure of the inspected wafer comprises silicon.

20. The application according to the preceding claim, **characterized in that** the structure of the inspected wafer comprises an SOI-type structure.

## Patentansprüche

1. Vorrichtung zur Kontrolle des Oberflächenzustands von Platten, die eine Messung der Verbindungsgeschwindigkeit zweier Platten (11,12) im Bereich (13) einer Verbindungskontaktfläche einsetzt, die zwischen den beiden Platten definiert ist, die eine Scheibe bilden, wobei die Vorrichtung Mittel zum Zusammendrücken umfasst, die dafür eingerichtet sind, die Scheibe in einem festgelegten Punkt (X1) dieser Scheibe zusammenzudrücken, **dadurch gekennzeichnet, dass** die Vorrichtung außerdem Folgendes umfasst: ein Mittel zur automatischen Detektion des Beginns des Verbindungsvorgangs, das dafür eingerichtet ist, den Zeitpunkt festzustellen, zu dem die Scheibe durch das Mittel zum Zusammendrücken zusammengedrückt wird, und ein Mittel zur automatischen Detektion des Durchgangs einer Verbindungswelle, das eine Quelle (30) für elektromagnetische Strahlung und einen Sensor (40), der dafür geeignet ist, wenigstens einen Teil des Spektrums der von der Quelle (30) emittierten elektromagnetischen Strahlung zu detektieren, umfasst, wobei der Sensor (40) so angeordnet ist, dass er die von einer bestimmten Messstelle (X) der Verbindungskontaktfläche kommende Strahlung erfasst.

2. Vorrichtung nach dem vorhergehenden Anspruch, **dadurch gekennzeichnet, dass** die Vorrichtung eine Verarbeitungseinheit umfasst, an die das Mittel zur automatischen Detektion des Beginns des Verbindungsvorgangs und das Mittel zur automatischen Detektion des Durchgangs einer Verbindungswelle angeschlossen sind.

3. Vorrichtung nach dem vorhergehenden Anspruch, **dadurch gekennzeichnet, dass** die Verarbeitungseinheit dafür eingerichtet ist, für jede Messstelle der Verbindungskontaktfläche momentane Verbindungsgeschwindigkeiten zu berechnen.

4. Vorrichtung nach einem der vorhergehenden Ansprüche, **dadurch gekennzeichnet, dass** der Sensor (40) dafür eingerichtet ist, eine Veränderung einer Eigenschaft der elektromagnetischen Welle festzustellen, die er über wenigstens eine zwischengeschaltete Messstelle von der Quelle (30) empfängt.

5. Vorrichtung nach dem vorhergehenden Anspruch, **dadurch gekennzeichnet, dass** die Veränderung einer Eigenschaft der elektromagnetischen Welle eine Kontraständerung ist.

6. Vorrichtung nach einem der vorhergehenden Ansprüche, **dadurch gekennzeichnet, dass** das Mittel zur automatischen Detektion des Durchgangs einer Verbindungswelle unter anderem und in Verbindung mit wenigstens einer Messstelle eine zugehörige Öffnung umfasst, die durch den Träger hindurch verläuft und die die von der Quelle ausgehende Strahlung passieren lässt, damit diese anschließend die Platten im Bereich der Messstelle durchdringen kann, damit der Teil der von der Quelle ausgehenden Strahlung, der durch die Platten hindurch gelaufen ist, in den Sensor gelangen kann.

7. Vorrichtung nach dem vorhergehenden Anspruch, **dadurch gekennzeichnet, dass** das Detektionsmittel wenigstens eine Detektionseinheit (50) umfasst, die aus einer elektromagnetischen Quelle (30), einer Öffnung (21) und einem elektromagnetischen Sensor (40) gebildet wird, und dies derart, dass die Quelle (30) und der Sensor (40) auf beiden Seiten der Öffnung (21) ausgerichtet sind.

8. Vorrichtung nach einem der vorhergehenden Ansprüche, **dadurch gekennzeichnet, dass** das Mittel zur automatischen Detektion des Durchgangs einer Verbindungswelle unter anderem und in Verbindung mit wenigstens einer Messstelle eine Quelle für elektromagnetische Strahlung umfasst, die auf die Messstelle ausgerichtet ist und die von den Platten in Richtung eines zugehörigen Sensors reflektiert wird.

9. Vorrichtung nach einem der vorhergehenden Ansprüche, **dadurch gekennzeichnet, dass** die Quelle (30) vom Typ einer Lampe ist.

10. Vorrichtung nach einem der vorhergehenden Ansprüche, **dadurch gekennzeichnet, dass** der Sensor (40) optoelektronisch ist.

11. Vorrichtung nach einem der vorhergehenden Ansprüche, **dadurch gekennzeichnet, dass** das von der Quelle (30) emittierte elektromagnetische Spektrum den Bereich des Infraroten umfasst.

12. Vorrichtung nach einem der elf vorhergehenden Ansprüche, **dadurch gekennzeichnet, dass** die Vorrichtung mehrere Einheiten (50) zur Detektion des Durchgangs einer Verbindungswelle zwischen den beiden Platten umfasst, denen mehrere jeweils zugehörige Messstellen für die zu kontrollierenden Platten zugeordnet sind, und dies derart, dass jede dieser Einheiten eine lokale Bestimmung eines Zeitpunkts der lokalen Verbindung im Bereich der zughörigen Messstelle gestattet.

13. Vorrichtung nach dem vorhergehenden Anspruch in Kombination mit Anspruch 6 oder 7, **dadurch gekennzeichnet, dass** das Mittel zur automatischen Detektion des Zeitpunkts der Verbindung mehrere Öffnungen (21) umfasst, die jeweils zu Messstellen gehören, wobei jede Öffnung (21) eine lokale Detektion des Zeitpunkts der lokalen Verbindung im Bereich der zugehörigen Detektionszone gestattet.

14. Verfahren zur Kontrolle des Oberflächenzustands von Platten, das eine Messung der Verbindungsgeschwindigkeit zweier Platten (11,12) im Bereich einer Verbindungskontaktfläche (13) einsetzt, die zwischen zwei Platten definiert ist, die eine Scheibe bilden, **dadurch gekennzeichnet, dass** das Verfahren die folgenden Vorgänge umfasst:
• Zusammendrücken der Scheibe in einem festgelegten Punkt (X1) dieser Scheibe,
• automatisches Erfassen eines Anfangszeitpunkts des Verbindungsvorgangs durch die Detektion des Zeitpunkts, zu dem die Scheibe zusammengedrückt wird,
• automatisches Erfassen eines Zeitpunkts des Durchgangs einer Verbindungswelle im Bereich einer Messstelle der Platten (11, 12), und dies ausgehend von einer Veränderung einer Eigenschaft einer von der Messstelle kommenden elektromagnetischen Welle,
• automatisches Bestimmen einer Verbindungsgeschwindigkeit, ausgehend von diesen beiden Erfassungen.

15. Verfahren nach dem vorhergehenden Anspruch, **dadurch gekennzeichnet, dass** die Veränderung einer Eigenschaft der elektromagnetischen Welle eine Kontraständerung ist.

16. Verfahren nach einem der zwei vorhergehenden Ansprüche, **dadurch gekennzeichnet, dass** das Spektrum der elektromagnetischen Welle den Bereich des Infraroten umfasst.

17. Verfahren nach einem der drei vorhergehenden Ansprüche, **dadurch gekennzeichnet, dass** mehrere Zeitpunkte des lokalen Durchgangs einer Verbindungswelle in mehreren jeweils zugehörigen Messstellen der Platten detektiert werden.

18. Anwendung einer Vorrichtung nach einem der Ansprüche 1 bis 13 oder eines Verfahrens nach einem der Ansprüche 14 bis 17 zur Kontrolle des Oberflächenzustands einer Platte mit einer mittleren Dicke, die zwischen einem Mikrometer und einigen Millimetern liegt.

19. Anwendung nach dem vorhergehenden Anspruch, **dadurch gekennzeichnet, dass** die Zusammensetzung der kontrollierten Platte Silizium umfasst.

20. Anwendung nach dem vorhergehenden Anspruch, **dadurch gekennzeichnet, dass** die Zusammensetzung der kontrollierten Platte eine Struktur vom SOI-Typ umfasst.
